Europäisches Patentamt

European Patent Office

Office européen des brevets

(11) Publication number: **0 253 982 B1**

# EUROPEAN PATENT SPECIFICATION

(45) Date of publication of patent specification: **23.09.92**   (51) Int. Cl.⁵: **H01H 50/02**, H01H 50/10

(21) Application number: **87107220.3**

(22) Date of filing: **27.04.84**

(60) Publication number of the earlier application in accordance with Art.76 EPC: **0 124 109**

(54) **Electromagnetic relay.**

(30) Priority: **12.08.83 JP 126061/83 U**

(43) Date of publication of application:
**27.01.88 Bulletin 88/04**

(45) Publication of the grant of the patent:
**23.09.92 Bulletin 92/39**

(84) Designated Contracting States:
**AT BE CH DE FR GB IT LI LU NL SE**

(56) References cited:
**DE-A- 2 025 134      DE-A- 2 429 775**
**DE-B- 2 146 407      DE-U- 7 604 690**
**GB-A- 2 027 278      US-A- 3 987 263**

(73) Proprietor: **OMRON TATEISI ELECTRONICS CO.**
**10, Tsuchido-cho Hanazono Ukyo-ku Kyoto-shi Kyoto-fu(JP)**

(72) Inventor: **Maenishi, Kozo§Omron Tateisi Electronics Co.**
**Patent Dept. 20 Igadera Shimo-Kaiinji Nagaokakyo-City Kyoto 617(JP)**
Inventor: **Nakanishi, Yoichi§Omron Tateisi Electronics Co.**
**Patent Dept. 20 Igadera Shimo-Kaiinji Nagaokakyo-City Kyoto 617(JP)**

(74) Representative: **WILHELMS, KILIAN & PARTNER Patentanwälte**
**Eduard-Schmid-Strasse 2**
**W-8000 München 90(DE)**

## Description

## BACKGROUND OF THE INVENTION

The present invention relates to an electromagnetic relay.

A problem that arises in particular with an electromagnetic relay for switching high frequency current is that of leakage of high frequency current between the various terminals thereof. It has been practiced to shield the body of the relay, and the mechanisms inside it, as much as practicable, but still the problem is not completely solved. Further, often shielding of the relay terminals is performed by providing a plated surface on the outside body of the relay from which the terminals protrude. When the relay is mounted to, for example, a printed circuit board, and is pressed thereagainst so as to engage the terminals well thereto, then this plated surface is brought into contact with a ground surface on the printed circuit board, and is thereby grounded. However, problems have arisen because, since this plated surface is pressed close against the printed circuit board, it is very difficult to eliminate all residue of flux between them. Such residual flux can cause corrosion, both of the terminals and of the plated surface itself, and this can result in poor electrical contact between the plated surface and the ground surface on the board, which can in turn cause unacceptable high leakage of high frequency current.

From DE-A-2 025 134 there is known a relay on the lower surface of a lower cover plate of which distance burls are integrally formed preventing a direct contact between a printed circuit board and the whole surface of the cover plate. There is no electrical connection of these distance burls or projections to a ground terminal.

A relay having terminals projecting through a base plate thereof and without any provision for keeping the base plate at a certain distance from a printed circuit board is known from DE-B-2 146 407.

A relay having a dust protection cover which is metalized at its inner surface is known from DE-U-76 04 690. Also here it is not provided for keeping the base plate of the relay at a certain distance from the printed circuit board.

From US-A-3 987 263 there is known a switching device for switching signals of very high and ultrahigh frequencies, having an insulating base and shielding walls between adjacent stationary contacts, which shielding walls project from the base a farther distance than contacts also projecting from the base do.

Object of the present invention is to provide such an electromagnetic relay, which does not suffer from undue leakage of high frequency current.

It is a further object of the present invention to provide such an electromagnetic relay, which provides continued good contact between a shielding surface thereof and a ground surface on a board to which it is mounted.

It is a yet further object of the present invention to provide such an electromagnetic relay, which is not subject to an accumulation of flux tending to remain between it and a printed circuit board to which it is fitted.

The present invention is defined in attached claim 1.

According to such a structure, when the relay is mounted, as for example to a printed circuit board, and is pushed thereagainst so as to engage said contact terminals and said ground terminals to contacts thereon, then the stop/shield projections prevent the relay being forced quite against said board so as to contact the surface of said base against the surface of said board. Thus, a gap is forced to remain between said base and said printed circuit board, and this is very effective for preventing the lingering of flux between the relay and the board. Accordingly the corrosion of the terminals or of the relay which might be caused by said flux is prevented. Further, since the stop/shield projections and the ground terminals are provided around the contact terminals, the leakage of high frequency current signals is prevented, and although this relay may be made very compact and at a high design density no problems arise with regard to such signal leakage. Accordingly this relay has superior high frequency characteristics.

The present invention will now be shown and described with reference to the preferred embodiments thereof, and with reference to the illustrative drawings.

Fig. 1 is a side view of a prior art type of relay;

Fig. 2 is a bottom view of the prior art relay of Fig. 1;

Fig. 3 is a graph, in which signal leakage between different poles is shown in dB and signal frequency is shown in MHz, illustrating the characteristics of leakage both in the prior art relay of Figs. 1 and in the first preferred embodiment of the relay of the present invention;

Fig. 4 is a partly broken away side view, similar to Fig. 1, showing the first preferred embodiment of the relay of the present invention, and also showing in section a printed circuit board for mounting it to;

Fig. 5 is a bottom view, similar to Fig. 2, showing said first preferred embodiment of the relay of the present invention;

Fig. 6 is a partly broken away side view, similar to Figs. 1 and 4, showing the second preferred embodiment of the relay of the present invention, and also showing a printed circuit board;

Fig. 7 is a bottom view, similar to Fig. 2 and 5, showing said second preferred embodiment of the relay of the present invention;

Fig. 8 is a partly broken away side view, similar to Figs. 1, 4, and 6, showing the third preferred embodiment of the relay of the present invention, and also showing a printed circuit board;

Fig. 9 is a bottom view, similar to Fig. 2, 5, and 7, showing said third preferred embodiment of the relay of the present invention;

Fig. 10 is a sectional view through said third preferred embodiment, taken in a plane shown by the arrows A - A in Fig. 8;

Fig. 11 is a partly broken away side view, similar to Figs. 1, 4, 6, and 8, showing the fourth preferred embodiment of the relay of the present invention, and also showing a printed circuit board;

Fig. 12 is a bottom view, similar to Fig. 2, 5, 7, and 9, showing said fourth preferred embodiment of the relay of the present invention.

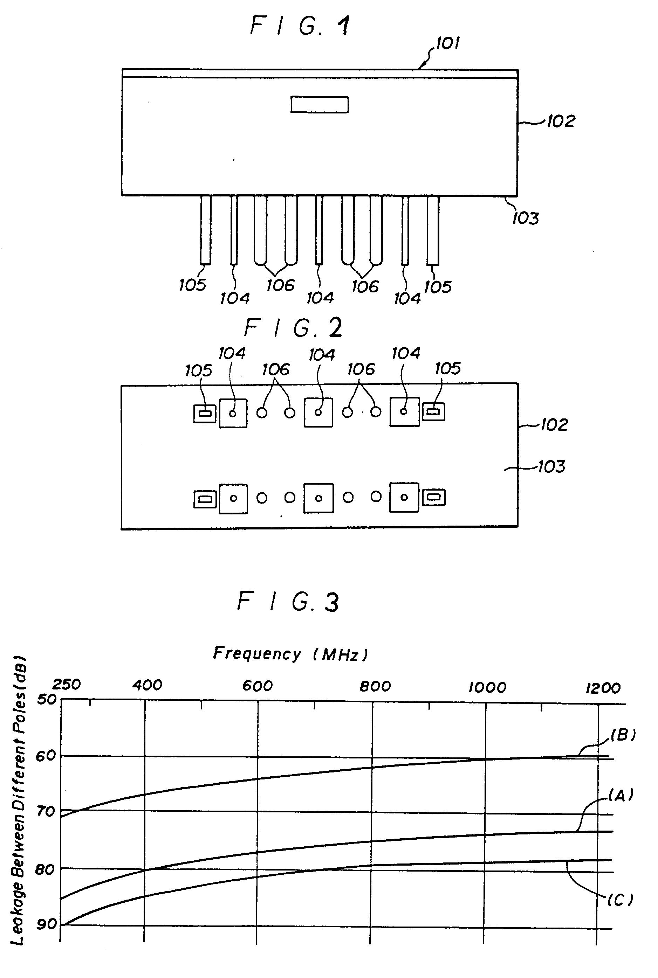

Now, the present invention will be discussed with particular reference to the first through the fourth preferred embodiments thereof. First, however, in Figs. 1 and 2 there is shown a prior art type relay, respectively in a side and in a bottom view. This relay is for switching a high frequency current, and it is intended to be mounted on a printed circuit board, not shown. In order to avoid the problem, which is becoming more and more pressing nowadays with the increasingly smaller size of high frequency relays, that the high frequency current tends to leak from one terminal to another because these terminals are being made closer to one another, this known relay 101 of Figs. 1 and 2 is made as follows. A casing 102 is mounted over a relay mechanism (not shown) fixed on a base 103, and out from the bottom of said base 103 project a plurality of contact terminals 104 for receiving switched signals, a plurality of coil terminals 105 for receiving a switching signal, and a plurality of ground terminals 106. The base 103 is coated both on its external and its internal surfaces with conductive plating such as Cu-Ni plating, except for the immediate surroundings of the contact terminals 104 and the coil terminals 105; and the internal plating and the external plating on said base 103 are electrically connected together, as are also the external plating and the ground terminals 106. Thus, when the relay 101 is mounted on a printed circuit board, not shown, each of the terminals 104, 105, and 106 is poked through a corresponding mounting hole on the printed circuit board, and a ground surface formed on the printed circuit board contacts the ground terminals 106 as well as contacting the plating formed on the outside surface (the lower surface in Fig. 1) of the base 103 of the relay 101.

When the grounding contact between the plated outer surface of the base 103 and the ground surface on the printed circuit board is present and good, as well as the grounding contact between the ground terminals 106 and said printed board ground surface, then the amount of leakage of a high frequency switched signal can be as good as -74dB at 900MHz, as shown by the exemplary line (A) in Fig. 3. However, problems tend to arise in such a prior art, because since the surface of the printed circuit board and the plated outer surface of the base 103 are in close contact with one another for providing electrical connec tion, it is very difficult to eliminate any flux that gets in between these two surfaces. Such remaining flux can corrode the terminals, causing bad connections, and further by such corrosion the contact area between the surface of the printed circuit board and the plated outer surface of the base 103 is diminished, thereby deteriorating the high frequency characteristics of the assembly. In such a case, if the electrical connection between the printed circuit board ground surface and the plated outer surface of the base 103 substantially fails, only leaving the electrical connection between the printed circuit board ground surface and the ground terminals 106, then the amount of leakage of a high frequency switched signal can deteriorate to be as bad as -61dB at 900MHz, as shown by the exemplary line (B) in Fig. 3.

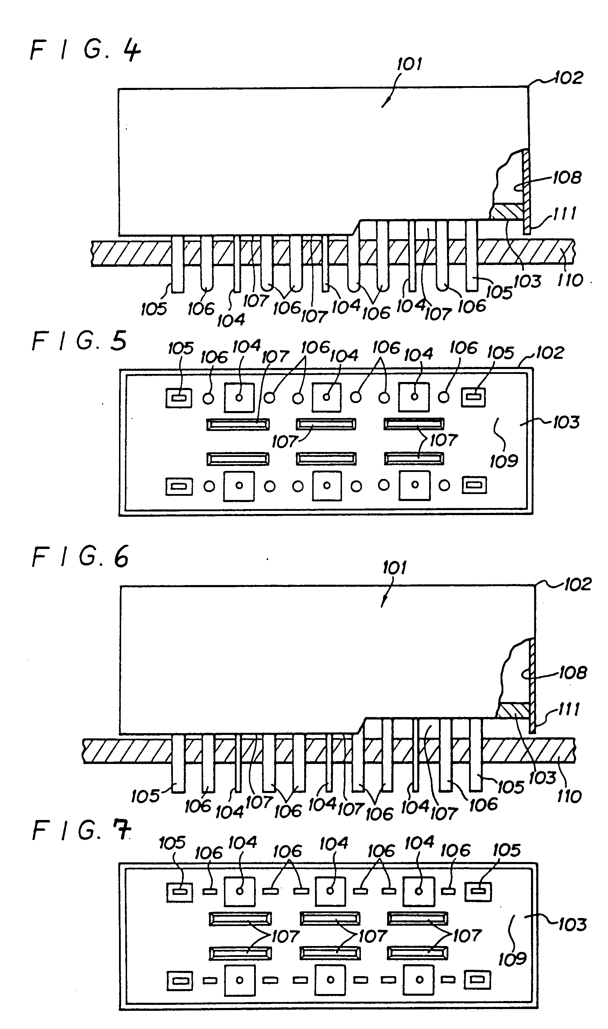

Now, in Figs. 4 and 5, a first preferred embodiment of the relay of the present invention is shown, which is so constructed as to avoid the above detailed problems. In this case, again a casing 102 is mounted over a relay mechanism (not shown, but in fact this is a two pole high frequency signal switching unit) fixed on a base 103, and the fringe 111 of the case 102 extends to some distance below the bottom of the base 103, as seen by the cutaway portion of Fig. 4. In the bottom of said base 103 and projecting out therefrom there are fixed: six contact terminals 104 for receiving switched signals, said contact terminals 104 being arranged in two longitudinally extending rows of three each; four coil terminals 105 for receiving a switching signal, each of said coil terminals 105 being provided at one longitudinal end of one of said two rows of three contact terminals 104; twelve ground terminals 106, one of which is provided on each longitudinal side of each of the contact terminals 104; and six stop/shield projections 107, which are much shorter in the vertical direction (perpendicular to the printed circuit board) than the terminals 104, 105, and 106 but are much longer than said terminals in the longitudinal direction, and which are provided one on the inside side of each of the contact terminals 104, being integrally formed with the base 103. Again, the base 103 is coated both on its external and its internal surfaces with conductive plating such as Cu-Ni plating, except for the immediate surroundings of the contact terminals 104 and the coil terminals 105 (according to this, squares and rectangles where the conductive plating is absent are shown in Fig. 5 as surrounding said terminals 104 and 105 - this configuration is obtained by masking during the plating process); and the internal plating and the external plating on said base 103 are electrically connected together, as are also the external plating and the ground terminals 106 and also the stop/shield projections 107. The shield plating formed of Cu-Ni on the inside of the case 102 is shown as 108 in Fig. 4. The length of each of the stop/shield projections 107 is slightly longer than the amount by which the fringe 111 of the case 102 projects downwards past the lower surface of the base 103, so that, when the relay 101 is mounted on a printed circuit board 110 as shown in Fig. 5 and is pushed firmly thereagainst, with each of the terminals 104, 105, and 106 poked through a corresponding mounting hole on the printed circuit board, then when the ends of the stop/shield projections 107 come into contact with the printed circuit board 110 a certain gap still is left between the fringe 111 of the case 102 and said printed circuit board 110, as well as a larger gap being left between the bottom outer surface of the base 103 and said printed circuit board 110. The end surfaces of the stop/shield projections 107 are flat, so that in this condition they well and properly contact the ground surface formed on the printed circuit board 110 (as well as of course do the ground terminals 106). Also these end surfaces of the stop/shield projections 107 are substantially parallel to the bottom surface of the bas e 103, again so as to ensure that they properly contact the ground surface of the printed circuit board 110.

Because of this gap left between the bottom outer surface of the base 103 and said printed circuit board 110, according to the provision of the stop/shield projections 107, it is much easier to ensure that no flux becomes trapped therebetween, and accordingly the risk of such trapped flux deteriorating the high frequency shielding characteristics of the relay is effectively prevented. The reason for the configuration shown in Figs. 4 and 5, with the ground terminals 106 on either side of each of the contact terminals 104, and with the elongated stop/shield projections 107 extending, on the inside side of each of the contact terminals 104, almost between the two corresponding ground terminals 106, is in order to better shield said contact terminals 104. As a modification of the shown embodiment, it would be possible to make each of the projections 107 in the form of a trough, in other words with an arcuate cross section from the point of view of Fig. 5 concave in the direction of the corresponding contact terminal 104; but this has not been done in the shown first preferred embodiment, in view of the desirability of facilitating the work of sealing the relay. Also, it would be possible to make the shown construction by integrally forming the stop/shield projections 107 with the base 103 of the relay, and by performing the Cu-Ni plating thereof later.

In the case of this first preferred embodiment, since the grounding contact between the plated outer surface of the base 103 and the ground surface on the printed circuit board through the projections 107 is virtually guaranteed to be present and good, and supplements effectively the grounding contact between the ground terminals 106 and said printed board ground surface, therefore the amount of leakage of a high frequency switched signal can be as good as -97dB at 900MHz, as shown by the exemplary line (C) in Fig. 3.

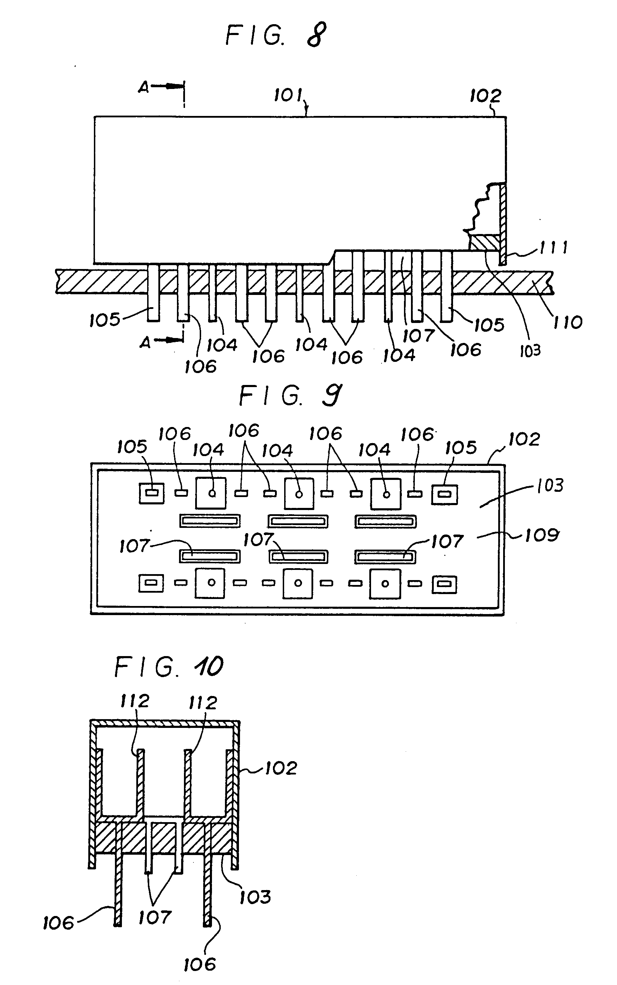

In Figs. 6 and 7, a second preferred embodiment of the relay of the present invention is shown, in a fashion similar to Figs. 4 and 5 with regard to the first preferred embodiment. As opposed to the first embodiment, in which the ground terminals 106 were integrally formed with the base 103, according to this embodiment, after forming the ground terminals 106 as reed frame type and then inserting them in the base 103, Cu-Ni plating was performed on the base 103. Thereby, the assembly work was made easier than it was in the first preferred embodiment.

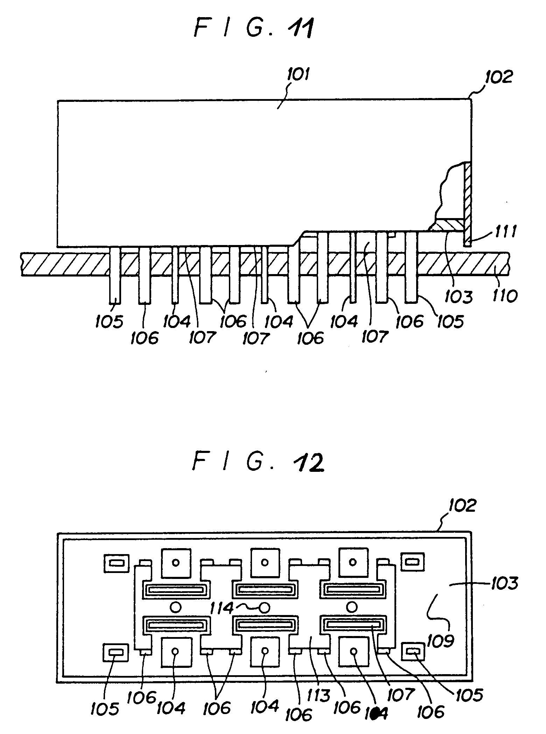

In Figs. 8 and 9, a third preferred embodiment of the relay of the present invention is shown, in a fashion similar to Figs. 4 and 5 with regard to the first preferred embodiment; and Fig. 10 shows a cross sectioal view of the relay in a plane shown by the arrows A - A in Fig. 8. As opposed to the first and second preferred embodiments, in which the high frequency insulation for the mechanism of the relay was provided by the Cu-Ni layer 108 on the inside of the case 102, in this third preferred embodiment a shield box 112 is formed from metallic plate and is fitted inside the relay 101 with the grounding terminals 106 and the stop/shield projections 107, which are integrally formed with and attached to said shield box 112, projecting through holes in the base 103, as best seen in section in Fig. 10. Thus, the electrical connection of the stop/shield projections 107 and the ground terminals 106 and the shielding material for the relay is effectively performed by a simple construction, in which plating work and other difficulties during assembly are eliminated.

In Figs. 11 and 12, a fourth preferred embodiment of the relay of the present invention is shown, in a fashion similar to Figs. 4 and 5 with regard to the first preferred embodiment. As opposed to the first and second preferred embodiments, in which the electrical connections between the ground terminals 106 and the stop/shield projections 107 were only made via the Cu-Ni plating on the surface of the base 103, in this fourth preferred embodiment these ground terminals 106 are constituted as downwards bent projections from a connecting body 113 which is made of a metal press formed plate and is fixed on the bottom of the base 103 and is located by projections 114 provided on the bottom surface of said base 103. With this connecting body 113 integrally connecting together the ground terminals 106 and also positively being pressed against and contacting the Cu-Ni plating on the bottom of the base 103 which is contacted with the stop/shield projections 107, the electrical connection between the ground terminals 106 and the stop/shield projections 107 is much more positively assured, and accordingly electrical integrity is improved.

## Claims

1. An electromagnetic relay comprising a base (103), a plurality of contact terminals (104) projecting from said base, a plurality of ground terminals (106) on the sides of each of the contact terminals (104), and a shielding connected to the ground terminals (106), **characterized** by a plurality of stop/shield projections (107) on the sides of the contact terminals (104), extending from said base (103) by substantially smaller distances than do said contact terminals (104) and said ground terminals (106), and electrically connected to said ground terminals (106).

2. An electromagnetic relay according to claim 1, **characterized** in that said stop/shield projections (107) all extend from said base (103) by substantially the same amount.

3. An electromagnetic relay according to claim 2, **characterized** in that the ends of said stop/shield projections (107) remote from said base (103) are formed with flat surfaces substantially parallel to said base (103).

4. An alectromagnetic relay according to any one of the preceding claims, **characterized** in that the electrical connection between said stop/shield projections (107) and said ground terminals (106) is provided by a metallic plated layer on said base (103).

5. An electromagnetic relay according to claim 4, **characterized** in that the electrical connection between said stop/shield projections (107) and said ground terminals (106) is further provided by a pressed contact between said metallic plated layer and an electrically conductive connecting body (113) which connects together said ground terminals (106).

6. An electromagnetic relay according to claim 1, **characterized** in that said stop/shield projections (107) and said ground terminals (106) are provided as integrally formed with a shield member (112) mounted within the body of said relay, and project through holes formed in said base.

## Patentansprüche

1. Elektromagnetisches Relais mit einer Basis (103), einer Anzahl von Kontaktanschlüssen (104), die von der Basis abragen, einer Anzahl von Masseanschlüssen (106) an den Seiten eines jeden der Kontaktanschlüsse (104) und einer mit den Masseanschlüssen (106) verbundenen Abschirmung, gekennzeichnet durch eine Anzahl von Anschlag/Abschirmungsvorsprüngen (107) an den Seiten der Kontaktanschlüsse (104), die sich von der Basis (103) um im wesentlichen kleinere Abstände, als dies die Kontaktanschlüsse (104) und Masseanschlüsse (106) tun, wegerstrecken und mit den Masseanschlüssen (106) elektrisch verbunden sind.

2. Elektromagnetisches Relais nach Anspruch 1, dadurch gekennzeichnet, daß die Anschlag/Abschirmungsvorsprünge (107) sich alle von der Basis (103) in gleichem Maße wegerstrecken.

3. Elektromagnetisches Relais nach Anspruch 2, dadurch gekennzeichnet, daß die von der Basis (103) entfernten Enden der Anschlag/Abschirmungsvorsprünge (107) mit zur Basis (103) im wesentlichen parallelen, ebenen Oberflächen ausgebildet sind.

4. Elektromagnetisches Relais nach irgendeinem der vorstehenden Ansprüche, dadurch gekennzeichnet, daß die elektrische Verbindung zwischen den Anschlag/Abschirmungsvorsprüngen (107) und den Masseanschlüssen (106) durch eine metallische auf die Basis (103) aufplattierte Schicht geliefert wird.

5. Elektromagnetisches Relais nach Anspruch 4, dadurch gekennzeichnet, daß die elektrische Verbindung zwischen den Anschlags/Abschirmungsvorsprüngen (107) und den Masseanschlüssen (106) ferner durch einen Preßkontakt zwischen der metallischen plattierten Schicht und einem elektrisch leitenden Verbindungskörper (113), der die Masseanschlüsse (106) miteinander verbindet, geliefert wird.

6. Elektromagnetisches Relais nach Anspruch 1, dadurch gekennzeichnet, daß die Anschlag/Abschirmungsvorsprünge (107) und die Masseanschlüsse (106) einstückig mit einem Abschirmungsteil (112), welches innerhalb des Relaiskörpers angebracht ist, vorgesehen sind und durch in der Basis ausgebildete Löcher herausragen.

**Revendications**

1. Un relais électromagnétique comprenant une base (103), plusieurs bornes de contact (104) faisant saillie de ladite base, plusieurs bornes de masse (106) situées sur les côtés de chacune des bornes de contact (104), et un moyen formant écran relié aux bornes de masse (106), caractérisé par plusieurs saillies de butée/écran (107) situées sur les côtés des bornes de contact (104), s'étendant à partir de ladite base (103) sur des distances sensiblement plus petites que lesdites bornes de contact (104) et lesdites bornes de masse (106), et reliées électriquement auxdites bornes de masse (106).

2. Un relais électromagnétique selon la revendication 1, caractérisé en ce que lesdites saillies de butée/écran (107) s'étendent toutes sensiblement de la même distance à partir de ladite base (103).

3. Un relais électromagnétique selon la revendication 2, caractérisé en ce que les extrémités desdites saillies de butée/écran (107) qui sont éloignées de ladite base (103) sont pourvues de surfaces plates sensiblement parallèles à ladite base (103).

4. Un relais électromagnétique selon une quelconque des revendications précédentes, caractérisé en ce que la liaison électrique entre lesdites saillies de butée/écran (107) et lesdites bornes de masse (106) est établie par une couche métallique de revêtement sur ladite base (103).

5. Un relais électromagnétique selon la revendication 4, caractérisé en ce que la liaison électrique entre lesdites saillies de butée/écran (107) et lesdites bornes de masse (106) est en outre établie par un contact de pression entre ladite couche métallique de revêtement et un corps de liaison (103) électriquement conducteur qui relie ensemble lesdites bornes de masse (106).

6. Un relais électromagnétique selon la revendication 1, caractérisé en ce que lesdites saillies de butée/écran (107) et lesdites bornes de masse (106) sont créées en étant formées unitairement avec un élément formant écran (112), monté à l'intérieur du corps dudit relais, et elles font saillie à travers des trous formés dans ladite base.

## F I G. 1

101

102

103

105  104  106  104  106  104  105

## F I G. 2

105  104  106  104  106  104  105

102

103

## F I G. 3

Frequency (MHz)

Leakage Between Different Poles (dB)

250  400  600  800  1000  1200

50

60          (B)

70          (A)

80

90          (C)

F I G. 4

F I G. 5

F I G. 6

F I G. 7

FIG. 8

FIG. 9

FIG. 10

9

EP 0 253 982 B1

F I G. 11

F I G. 12